(19) Europäisches Patentamt
European Patent Office
Office européen des brevets

(11) EP 1 060 565 B1

(12) **EUROPÄISCHE PATENTSCHRIFT**

(45) Veröffentlichungstag und Bekanntmachung des Hinweises auf die Patenterteilung:
**17.04.2002 Patentblatt 2002/16**

(21) Anmeldenummer: **99907294.5**

(22) Anmeldetag: **28.01.1999**

(51) Int Cl.[7]: **H03M 7/00**

(86) Internationale Anmeldenummer:
**PCT/DE99/00213**

(87) Internationale Veröffentlichungsnummer:
**WO 99/39441 (05.08.1999 Gazette 1999/31)**

(54) **KOMPRESSION VON DATEN MIT SYNTAKTISCHER STRUKTUR**
COMPRESSION OF DATA WITH A SYNTACTIC STRUCTURE
COMPRESSION DE DONNEES A STRUCTURE SYNTAXIQUE

(84) Benannte Vertragsstaaten:
**AT BE CH DE ES FI FR GB IE IT LI LU NL SE**

(30) Priorität: **31.01.1998 DE 19803845**

(43) Veröffentlichungstag der Anmeldung:
**20.12.2000 Patentblatt 2000/51**

(73) Patentinhaber: **Syntion AG**
**80636 München (DE)**

(72) Erfinder:
- **Eck, Peter**
  **82319 Starnberg (DE)**
- **Matzner, Rolf**
  **80798 München (DE)**
- **Xie, Changsong**
  **81739 München (DE)**

(74) Vertreter: **Bohnenberger, Johannes, Dr. et al**
**Meissner, Bolte & Partner**
**Postfach 86 06 24**
**81633 München (DE)**

(56) Entgegenhaltungen:
**US-A- 5 678 052**

- **R. CAMERON: "Source encoding using syntactic information source models" IEEE TRANSACTIONS ON INFORMATION THEORY, Bd. 34, Nr. 4, Juli 1988 (1988-07), Seiten 843-850, XP000212382**
- **J. KATAJAINEN: "Syntax-directed compression of program files" SOFTWARE-PRACTICE AND EXPERIENCE, Bd. 16, Nr. 3, März 1986 (1986-03), Seiten 269-276, XP002013872**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 060 565 B1

## Beschreibung

Die Erfindung betrifft ein Verfahren und eine Einrichtung zur Übertragung einer durch digitale Daten repräsentierten Nachricht nach Anspruch 1 bzw. 5.

### 1 Einführung in den Themenkreis

Wichtige technische Anwendungen der Quellencodierung liegen auf dem Gebiet der Übertragung und Speicherung von Nachrichten. Aus dem Wunsch einer geringen Datenrate bei der Übertragung von Nachrichten, bzw. eines geringen Platzbedarfs bei der Speicherung von Nachrichten, erwächst die Forderung nach einer möglichst kurzen, d. h. redundanzarmen und im Idealfall redundanzfreien Codierung der Nachricht.

### 2 Stand der Technik

### 2.1 Formen der Redundanz

Redundanz tritt in Quellensymbolströmen in zweierlei grundlegenden Formen in Erscheinung: Als unterschiedliche Auftrittshäufigkeit der Elemente des Quellensymbolvorrats, und in Form von statistischen Abhängigkeiten zwischen zeitlich auseinander liegenden Quellensymbolen, die ihre Ursache meist in quellenspezifischen Bildungsgesetzen für die Konstruktion von Nachrichten als Folge von Quellensymbolen haben.

### 3 Nachteile bekannter Verfahren

Zur Kompaktierung redundanzbehafteter Quellen, deren abgegebenen Quellensymbole nicht gleichverteilt, aber statistisch unabhängig sind, ist ein Verfahren nach Huffman [1] bekannt. Speziell für diesen Quellentyp geeignet, ist es mit dem Verfahren nur unter der günstigsten Voraussetzung möglich, daß die statistischen Eigenschaften der Quelle bekannt sind oder zuverlässig geschätzt werden können, eine maximale Kompaktierung zu erreichen.

Während die Schätzung der für Huffman-Codierung notwendigen Auftrittswahrscheinlichkeiten einzelner Quellensymbole auch bei mäßig langen Nachrichten ausreichend genau möglich ist, erfordert die Schätzung statistischer Abhängigkeiten zwischen zeitlich auseinander liegenden Quellensymbolen in der Regel eine umfassende Beobachtung der Quelle, die technische Machbarkeit (Speicherplatz) und verfügbaren Beobachtungszeitraum bei weitem übersteigen. Deswegen trifft das bekannte oder ähnliche Verfahren stets Annahmen über das zugrundeliegende Bildungsgesetz oder wesentliche Charakteristika desselben, und ist dann natürlich auch nur für Quellen mit diesem Bildungsgesetz geeignet. Diese Einschränkung gilt auch für das Ende der 70er Jahre durch Lempel-Ziv (LZ) bekannte Datenkompaktierungsverfahren [2]. Dieses Verfahren ist zur Kompaktierung beliebiger linearer Symbolfolgen geeignet, d. h. es ist anwendbar ohne Kenntnis der statistischen Eigenschaften der Nachrichtenquelle. Hauptanwendungsgebiete sind heute die Kompaktierung von Bilddaten (GIF-Dateiformat) und beliebiger Dateien (Archivierungsprogramme gnuzip, pkzip). Im Gegensatz zur Huffmann-Codierung nutzt dieses Verfahren, zwischen zeitlich aufeinanderfolgenden Symbolen bestehende, statistische Abhängigkeiten durch Berücksichtigung wiederholt auftretender Teilsymbolfolgen (Strings) aus. Damit ist LZ-Kompaktierung nur für solche Quellen geeignet, deren Bildungsgesetz zum häufigen Auftreten bestimmter Strings führt. Die Redundanz, die durch das Befolgen grammatikalischer Regeln bei der Konstruktion einer Nachricht in diese eingebracht wird, ist den bekannten Kompaktierungsverfahren aufgrund der rekursiven Struktur grammatikalischer Regeln nicht zugänglich, da sie lediglich Symbolhäufigkeiten oder sich wiederholende Zeichenketten zur Kompaktierung heranziehen.

Aus dem Aufsatz "Source encoding using syntactic information source models", R. Cameron, IEEE transactions on information theory, Bd. 34, Nr. 4, Juli 1988, S. 843-850, ist ein Verfahren zur Kompression digitaler Daten bekannt, deren Struktur durch eine Grammatik definiert wird. Eine zu codierende Nachricht wird in eine Sequenz von Symbolen überführt, welche dann entsprechend einer Codierprozedur gemäß einer festgelegten Reihenfolge abgearbeitet wird. Die erzeugte Sequenz von Symbolen definiert die sukzessive Anwendung grammatikalischer Regeln zur Bildung der codierten Nachricht, und die Decodierung erfolgt entsprechend basierend auf den codierten Daten. In weiteren Verfahrensschritten wird ein Parsebaum erzeugt, und die Baumknoten werden mit syntax-orientiert codierten (SoC-)Symbolen codiert, welche die angewendete Regel eindeutig identifizieren. Die erzeugten Symbole werden entsprechend einer festgelegten Reihenfolge der Traversierung aller Knoten des Parsebaums verkettet. Das beschriebene Verfahren wird allerdings nur zum Komprimieren von zu speichernden Daten verwendet, insbesondere zum Komprimieren von Daten in der Programmiersprache Pascal.

Aufgabe der vorliegenden Erfindung ist es daher, das vorgenannte Verfahren derart weiterzubilden, daß es vorteilhaft zur Übertragung einer durch digitale Daten repräsentierten Nachricht, die insbesondere Codesegmente eines Programms aufweist, eingesetzt werden kann.

Diese Aufgabe wird durch ein Verfahren mit den in Anspruch 1 angegebenen Merkmalen und eine Einrichtung mit den in Anspruch 5 genannten Merkmalen gelöst. Bevorzugte Ausgestaltungen des Verfahrens und der Einrichtung sind in den abhängigen Ansprüchen angegeben.

## 5 Vorteile der erfinderischen Lösung

Mit der erfindungsgemäßen Lösung, eine Datenreduktion in Abhängigkeit zur verwendeten Programmiersprachensyntax vornehmen zu können, ist es nunmehr in besonders vorteilhafter Weise möglich, Redundanz in Nachrichten, die sich während ihrer Konstruktion, wegen der Notwendigkeit, bestimmte grammatikalische Regeln beachten zu müssen, ergibt, asymptotisch nahezu vollständig zu entfernen.

Die Erfindung hat dies durch analytische Berechnung der Kapazität ihres syntax-orientiert codierten Datenstroms am Beispiel einer Sprache mit für Programmiersprachen typischen Charakteristika (mathematische Ausdrücke, if-then-else-Konstrukt, etc.) bewiesen. Dabei zeigte sich, daß ein nicht geringer Anteil der Redundanz, der im Aufgabenbereich herkömmlicher Verfahren (Lempel-Ziv, Huffmann) liegt, durch diese bisher nicht beseitigt wird.

Das neue Verfahren der syntax-orientierten Codierung ist dagegen in der Lage, die Datenmenge z. B. bezogen auf ein Komprimierungsergebnis nach dem Lempel-Ziv-Verfahren noch einmal um nahezu die Hälfte zu mindern.

Damit sind das erfindungsgemäße Verfahren und die zu seiner Ausführung definierten Einrichtungen für alle Anwendungen prädestiniert, welche die Übertragung oder Speicherung von syntaktisch strukturierten Nachrichten beinhalten. Beispiele sind die Übertragung von Java-Applets im Internet oder Intranet, die Übertragung oder Speicherung von Postscript-Dateien, die Übertragung und Speicherung von MPEG-4-codierten Videodaten, oder die Verwendung höherer Protokolle bei der Kommunikation. Gerade für die Übertragung von Programmen, wie z. B. Java-Applets, ist SoC (Syntax-orientierte Codierung) in besonderem Maße geeignet, da der Parser sowohl Bestandteil eines Compilers als auch eines SoC-Coders ist, und somit SoC organisch in den Datenfluß von der Programmerstellung bis zum Programmablauf integriert werden kann.

## 6 Wirkungsweise der Erfindung

### 6.1 Syntaktisch strukturierte Quelle

Die Erfindung geht von einer formalen Sprache aus, welche durch eine Menge von Zeichenketten dargestellt wird. Die Zusammenstellung der Nachricht erfolgt dabei nach einer der Sprache zugeordneten Grammatik. Eine Grammatik ist sowohl das mathematische System zur Definition einer formalen Sprache, als auch ein Satz von Regeln zur Feststellung der syntaktischen Gültigkeit eines konkreten Satzes. Im folgenden werden nur kontextfreie Grammatiken betrachtet, da höhere Programmiersprachen (C, C++, Java etc.) fast ausschließlich durch kontextfreie Grammatiken beschrieben werden. Eine kontextfreie Grammatik ist folgendermaßen definiert:

**Definition 1** Eine kontextfreie Grammatik ist ein e-Tupel G = (N, T, P, S), wobei

N die Menge der Nonterminalsymbole,

T die Menge der Terminalsymbole, und

P die Relation $N^*(N \cup T)^*$ ist.

S ist ein besonderes Nonterminalsymbol, auch Startsymbol genannt.

**Definition 2** Ein Element $(A, \beta) \in P$ heißt Produktion und wird abkürzend $A \rightarrow \beta$ geschrieben.

Eine Produktion (oder Ableitung) ist somit eine Ersetzungsregel für ein Nonterminalsymbol A, wobei dieses Nonterminalsymbol durch einen String (Kette) $\beta$ aus (Nonterminal- und) Terminalsymbolen ersetzt wird.

Existieren mehrere Produktionen $(A, \beta_1)$, $(A, \beta_2)$, ..., $(A, \beta_n) \in P$, so schreiben wir hierfür:

$$\begin{aligned} A \rightarrow\ & \beta_1 \\ \mid\ & \beta_2 \\ & \vdots \\ \mid\ & \beta_n \end{aligned}$$

**Definition 3** Die Menge $P_{A0} \subseteq P$ aller möglichen Ableitungen für ein Nonterminalsymbol $A_0$

$$P_{A0} = \{(A, \beta) \in P : A = A_0\}$$

heißt auch die Menge der Alternativen für $A_0$. Die Entscheidung für die Anwendung einer konkreten Produktion $(A_0, \beta_k) \in P_{A0}$, (k = 1, 2, ..., n) nennen wir Auswahl.

**Beispiel 1** Alle arithmetischen Ausdrücke in der Variablen a mit den Operatoren + und * sowie beliebig verschachtelten Klammern (, ) sind eine formale Sprache, die durch die Grammatik

$$G = (\{E, T, F\}, \{a, +, *, (,)\}, P, E)$$

erzeugt wird. P besteht aus den folgenden Produktionen:

$$
\begin{array}{lll}
E & \rightarrow & E+T \\
 & | & T \\
T & \rightarrow & T*F \\
 & | & F \\
F & \rightarrow & (E) \\
 & | & a
\end{array}
$$

a*a+(a*a+a)*a ist beispielsweise ein gültiger Satz.

Bei der Erzeugung eines Satzes werden Strings aus Nonterminal- und ggf. Terminalsymbolen durch Anwendung passender Produktionen auf die Nonterminalsymbole weiter abgeleitet, bis letztendlich der String nur noch aus Terminalsymbolen besteht. Im o. g. Beispiel besteht der gültige Satz nur noch aus den Terminalsymbolen a, +, *, (,).

## 6.2 Prinzip der Syntax-orientierten Codierung (SoC)

Information fließt in eine erzeugte Nachricht immer dann ein, wenn bei ihrer Konstruktion Entscheidungen getroffen werden. Entscheidungen sind dann zu treffen, wenn von mehreren möglichen Quellensymbolen eines auszuwählen ist, oder - bei einer syntaktisch strukturierten Quelle - von mehreren anwendbaren Produktionen $A \rightarrow \beta_1$, $A \rightarrow \beta_2$, ... genau die Produktion Anwendung findet (Auswahl, vgl. Definition 3).

SoC codiert anstelle des Strings aus Terminalsymbolen die Auswahlen, die der Reihe nach bei der Konstruktion dieses Strings (der Nachricht) vorgenommen werden.

**Definition 4** $\Sigma = \{\sigma_1, \sigma_2, ..., \sigma_n\}$ heißt SoC-Alphabet mit

$$n = \max_{A} \{|P_A|\}$$

Alle Elemente einer jeden Menge von Alternativen $P_\alpha$ werden mit SoC-Symbolen $\sigma_i \in \Sigma$ (beliebig) durchnummeriert:

**Definition 5:** $Z_A : P_A$ ist eine (beliebige) injektive Abbildung.

Die konkrete Definition von $z_A$ kann i. a. abhängig von $P_A$ sein

Zur Veranschaulichung der Erfindung sind nachfolgend Ausführungsbeispiele näher beschrieben und in den Fig. 1 bis 6 dargestellt. Es zeigen

- Fig. 1 ein Blockschaltbild eines SoC-Übertragungssytems
- Fig. 2 Alternativen der Grammatik G und mit SoC-Symbolen attributierte Auswahlen
- Fig. 3 einen Parse-Baum des Satzes a*a+(a*a+a) *a mit Entstehung der linearen SoC-Symbolfolge 121222121121222222
- Fig. 4 ein Flußdiagramm der Stack-Maschine (Kellerautomat)
- Fig. 5 ein besonderes Beispiel für ein SoC-Übertragungssystem mit empfängerseitiger Quelltextausgabe
- Fig. 6 ein Beispiel für ein SoC-Übertragungssystem mit lauffähigem Java-Applet bzw. -Applikation als Ausgabe

Die Funktion eines Übertragungssystems mit SoC ist in Fig. 1 veranschaulicht. Grundsätzlich sind Übertragung und Speicherung im Hinblick auf die Wirkungsweise der Codierung gleichzusetzen.

Die Quelle liefert einen syntaktisch strukturierten Symbolstrom (Quellprogramm). Elementarer Bestandteil des SoC-Coders ist der Parser, dessen Aufgabe es ist, aus der zunächst linearen Folge von Quellensymbolen die grammatikalische Struktur des Satzes (des Quellenprogramms) wiederzugewinnen. Diese grammatikalische Struktur wird i. a. durch einen Parse-Baum dargestellt, der seinerseits als Eingabe für den Coder dient. Der Coder erzeugt durch Codierung des Parse-Baumes eine lineare Folge von SoC-Symbolen, wobei das jeweils aktuelle SoC-Symbol in Abhängigkeit de aktuellen Auswahl ausgegeben und übertragen wird. Der SoC-Decoder baut aus der linearen Folge von SoC-Symbolen zunächst den Parse-Baum wieder auf, um dann durch dessen Traversieren die von der Quelle abgegebene Folge von Terminalsymbolen zu rekonstruieren.

## 6.3 Codierung

Die elementare Aufgabe des Parsers besteht darin, die bei der Konstruktion des Satzes von der Quelle getroffenen Auswahlen zu rekonstruieren. Ein Parse-Schritt bedeutet also die Feststellung der konkreten Produktion $(A, \beta) \in P_A$, die auch die Quelle zur Konstruktion der Nachricht an dieser Stelle ausgewählt hatte. Der Coder ordnet entsprechend Definition 5 der solchermaßen festgestellten Auswahl das zugehörige SoC-Symbol $\sigma_k = z_A((A, \beta))$ zu und attributiert den entsprechenden Knoten im Parse-Baum mit $\sigma_k$.

Durch Traversieren des Parse-Baumes wird schließlich die lineare Folge von SoC-Symbolen erzeugt und ausgegeben. In den Beispielen dieses Beitrags wird hierfür stets ein Algorithmus verwendet. Der Prozeß der Codierung soll anhand eines beispielhaften Parse-Baumes und der zugrundeliegenden Grammatik

aus Beispiel 1 näher erläutert werden.

**Beispiel 2** Gegeben ist die kontextfreie Grammatik aus Beispiel 1. Alle Alternativen, d. h. alle Ableitungsmöglichkeiten für jedes Nonterminalsymbol sind in der Fig. 2 graphisch dargestellt. Da die mächtigste Menge von Alternativen genau zwei Elemente hat, genügt das SoC-Alphabet $\Sigma = \{1, 2\}$. Jede Auswahl aller Mengen von Alternativen von Alternativen wird mit einem SoC-Symbol attributiert. Beispielsweise wird die Auswahl der konkreten Produktion $T \rightarrow T*F$ mit dem SoC-Symbol 1 attributiert.

Ein gültiger Satz der Grammatik ist dann also z. B.: a*a+(a*a+a)*a Den Parse-Baum für diesen Satz und die Entstehung der SoC-Symbolfolge durch Depth-first-Traversieren zeigt Fig. 3.

### 6.4 SoC mit arithmetischer Codierung

Das vorstehend erläuterte Verfahren ist nur dann effizient, wenn

1. $|P_A| = \text{const}\ \forall A$, und

2. $P((A, \beta_i)|A) = \text{const}\ \forall A, \beta_i$

Wobei $P((A, \beta_i)|\alpha)$ die bedingte Wahrscheinlichkeit der $\beta_i$ erzeugten Auswahl der Menge der Alternativen $P_A$ bezeichnet.

Diesem Mangel kann durch arithmetische Codierung [3] des SoC-Alphabets $\Sigma$ gemäß Anspruch 3 und 4 abgeholfen werden. Die für die arithmetische Codierung verwendeten Wahrscheinlichkeitsverteilungen der SoC-Symbole sollten in einer Adaptionseinrichtung nach Anspruch 7 adaptiert werden. Anstelle der linearen Sequenz von SoC-Symbolen wird der vom arithmetischen Coder erzeugte Bitstrom übertragen.

### 6.5 Decodierung

Die Decodierung ist der inverse Prozeß zur Codierung. Der Decoder formatiert die SoC-Codes zurück zum ursprünglichen Satz (Strings von Terminalsymbolen). Er arbeitet nach dem in den Ansprüchen 1 bzw. 2 beschriebenen Verfahren und wird durch eine Stack-Maschine [4] gemäß den Ansprüchen 5 bzw. 6 realisiert.

Ein Flußdiagramm für das Verfahren ist in Fig. 4 angegeben.

Zur Erläuterung der Stack-Maschine werden folgende Bezeichnungen eingeführt:

$\beta_k$ String von Terminal- und Nonterminalsymbolen

$\sigma$ SoC-Symbol

V Terminal- oder Nonterminalsymbol

S Startsymbol (Nonterminalsymbol)

Die Decodierung läuft damit in folgenden Schritten ab (die Schritt-Nummern korrespondieren mit den Bezugszeichen in Fig. 4):

S1. Die Entwicklung eines gültigen Satzes der Grammatik (eines Programms) beginnt mit dem Startsymbol S. Das Startsymbol S wird auf den Stack gelegt.

S2. Das oberste Symbol V wird vom Stack gelesen.

S3. Prüfen, ob V ein Nonterminalsymbol ist.

S4. Vom linearen Eingangs-SoC-Symbolstrom wird das nächste SoC-Symbol gelesen.

S5. Falls V ein Nonterminalsymbol ist, wird die Ableitung mit V weiterentwickelt. Durch $\sigma$ wird eine Auswahl $(V, \beta_k) = z^{-1}(\sigma)$ der Menge der Alternativen von $V \rightarrow \beta_1|\beta_2| \ldots |\beta_n$ für V bestimmt. Entsprechend der konkreten Auswahl wird V durch den String $\beta_k$ ersetzt.

S6. Der String $\beta_k$ von Symbolen (Terminal- und/oder Nonterminalsymbolen) wird auf den Stack gelegt.

S7. Falls V ein Terminalsymbol ist, wird es ausgegeben.

S8. Prüfen, ob der Stack leer ist.

S9. Die Stack-Maschine terminiert, wenn der Stack leer ist.

Die sukzessive ausgegebenen Strings von Terminalsymbolen ergeben miteinander verkettet schließlich den ursprünglich codierten Satz der Quelle.

### 7 Ausführungsbeispiel: bevorzugte Form der Anwendung

Die beiden in Fig. 5 und 6 dargestellten Ausführungsbeispiele unterscheiden sich lediglich durch die Datenausgabe am Empfänger (Ausgabe von Quelltext entsprechend dem Verfahren nach Anspruch 1 bzw. direkte Ausgabe eines lauffähigen Java-Applets bzw. einer lauffähigen Java-Applikation entsprechend dem Verfahren nach Anspruch 1).

1) Java-Quelle
Die Java-Quelle entspricht einem auf der Java-Grammatik beruhenden ASCII-Text, welcher aus Java-Programmtext sowie Kommentaren, Leerzeichen usw. besteht.

2) SoC-Encoder
Der SoC-Encoder setzt sich zusammen aus einem Compiler-Frontend (3, 4 und 6), einer Parse-Baum-Verarbeitung 5, einer Adaptiervorrichtung 8 und Modulen zur Kompression und Verkettung der erzeugten Daten.

3) Scanner
Der Scanner liest den Quelltext, entfernt die darin für das Programm unwichtigen Textstellen, wie Dokumentationen, Kommentare, Leerzeichen usw. und übergibt dem Parser 4 (Terminal-)Symbole

4) Parser
Der Parser interpretiert die (Terminal-)Symbole des Scanners 3, prüft ob die Symbolfolgen mit den grammatikalischen Regeln für Java übereinstimmen und erstellt den für dieses Programm spezifischen Parse-Baum. Zusätzlich wird die Symboltabelle 6 aufgebaut.

5) Bei der Initialisierung der Parse-Baum-Verarbeitung werden alle Knoten des Parse-Baumes mit für jeden Knotentyp festgelegten SoC-Symbolen attributiert. Die darauf folgende Traversierung aller Knoten des Parse-Baumes führt bei jedem Durchschreiten eines Knotens zur Ausgabe eines SoC-Symbols. Diese SoC-Symbole werden sowohl der Adaptiervorrichtung 8 als auch dem arithmetischen Coder 10 übergeben. Zusätzlich übergibt die Parse-Baum-Verarbeitung den aktuellen Knotentyp an die Adaptiervorrichtung 8.

6) Symboltabellenspeicher
Der Symboltabellenspeicher beinhaltet die vom Parser 4 extrahierten Bezeichner des Java-Programmtextes.

7) Zip-Kompressionseinrichtung
Der Inhalt der Symboltabelle 6 wird durch das Verfahren nach Lempel-Zip-Welch [2] komprimiert.

8) Sendeseitige Adaptiervorrichtung
Die Adaptiervorrichtung trägt bei der Initialisierung festgelegte Anfangswahrscheinlichkeitsverteilungen für jeden Knotentyp in der Wahrscheinlichkeitsverteilungstabelle 9 ein. Bei der laufenden Verarbeitung der von der Parse-Baum-Verarbeitung 5 übernommenen SoC-Symbole und anhand der aktuellen Knotentypen wird bei jedem Schritt die Wahrscheinlichkeitsverteilung aller SoC-Symbole des aktuellen Knotentyps adaptiert und in der Wahrscheinlichkeitsverteilungstabelle 9 eingetragen. Die Adaptiervorrichtung stellt gleichzeitig dem arithmetischen Coder 10 die zum jeweils aktuellen SoC-Symbol gehörende Wahrscheinlichkeitsverteilung zur Verfügung.

9) Tabelle der Wahrscheinlichkeitsverteilungen der SoC-Symbole
Für jeden Knotentyp enthält die Tabelle eine eigene Wahrscheinlichkeitsverteilung der SoC-Symbole des jeweiligen Knotentyps.

10) Arithmetischer Coder
Der Arithmetische Coder [3] empfängt von der Parse-Baum-Verarbeitung 5 das nächste zu codierende SoC-Symbol und codiert es unter Berücksichtigung der von der Adaptiervorrichtung 8 zur Verfügung gestellten Wahrscheinlichkeitsverteilung. Der Output des arithmetischen Coders ist ein binärer Datenstrom.

11) Datenverkettung
Der binäre Datenstrom des arithmetischen Coders 10 und die durch 7 komprimierte Symboltabelle 6 werden zu einem Datenpaket zusammengefaßt.

12) http-Server
Auf dem http-Server wird das in der Datenverkettung 11 erstellte Datenpaket abgelegt und zum Abruf auf einem Massenspeicher zur Verfügung gestellt.

13) Intranet/Internet

14) http-Client (Internet-Browser)
Der Browser hat die Aufgabe, das Datenpaket über das Intranet/Internet 13 von einem http-Server 12 zu laden und den Decodiervorgang durch den SoC-Decoder 15 anzustoßen.

15) SoC-Decoder
Der SoC-Decoder besteht im wesentlichen aus dem arithmetischen Decoder 17 und dem Kellerautomaten 22. Als Ergebnis liefert er die Sequenz der (Terminal-)Symbole, die dem ursprünglichen Java-Quellcode entsprechen (vgl. 3 und 4). (1).

16) Datenextraktion
Hier werden der binäre Datenstrom des arithmetischen Coders 10 und die durch Zip 7 komprimierte Symboltabelle aus dem gemeinsamen Datenpaket extrahiert und ersterer an den arithmetischen Decoder 17, letzterer an die Zipdekompressionseinrichtung 18 weitergegeben.

17) Arithmetischer Decoder
Der Arithmetische Decoder [3] decodiert adaptiv den binären Datenstrom von der Datenextraktion 16 unter Berücksichtigung der von der empfangsseitigen Adaptiervorrichtung 20 zur Verfügung gestellten Wahrscheinlichkeitsverteilungen zu den SoC-Symbolen und übergibt pro Decodierschritt ein SoC-Symbol an den Kellerautomaten 22.

18) Zip-Dekompressionseinrichtung
Die mit dem Verfahren nach Lempel-Ziv 7 komprimierte Symboltabelle des Coders (6) aus der Datenextraktion 16 wird entpackt und an den Symboltabellenspeicher des Decoders 19 eingetragen.

19) Symboltabellenspeicher des Decoders

20) Adaptiervorrichtung (empfangsseitig)
Die Initialisierung der empfangsseitigen Adaptiervorrichtung erfolgt analog zur sendeseitigen Adaptiervorrichtung 8. Während der laufenden Decodierung erhält die Adaptiervorrichtung bei jedem Decodierschritt ein SoC-Symbol, adaptiert die Wahrscheinlichkeitsverteilung der SoC-Symbole des aktuellen Knotentyps und trägt die adaptierten Wahrscheinlichkeitsverteilungen in die Wahrscheinlichkeitsverteilungstabelle 21 ein. Gleichzeitig stellt die empfangsseitige Adaptiervorrichtung die für den nächsten Decodierschritt gültige Wahrscheinlichkeitsverteilung dem arithmetischen Decoder zur Verfügung. Die Auswahl dieser Verteilung bestimmt sich durch den vom Kellerautomaten 22 festgelegten und im nächsten Decodierschritt zu erwartenden Knotentyp.

21) Tabelle der Wahrscheinlichkeitsverteilungen der SoC-Symbole
Für jeden Knotentyp enthält die Tabelle eine eigene Wahrscheinlichkeitsverteilung der SoC-Symbole dieses Knotentyps.

22) Kellerautomat
Die Initialisierung des Kellerautomaten, die Bearbeitung des Stapelspeichers sowie die Ausgabe von Terminalsymbolen ist in Fig. 4 als Flußdiagramm dargestellt. Zusätzlich übergibt der Kellerautomat Daten an die Adaptiervorrichtung 20:

a) Den jeweils aktuellen Knotentyp zur Adaption der Wahrscheinlichkeitsverteilungen der SoC-Symbole dieses Knotentyps
b) Den nächsten Knotentyp, dessen Wahrscheinlichkeitsverteilung der SoC-Symbole die Adaptiervorrichtung 20 im nächsten Decodierschritt dem arithmetischen Decoder 17 zur Verfügung stellen muß.

23) Stapelspeicher
Stapelspeicher (Stack) für den Kellerautomaten 22.

24) Java-Sinke
Wiedergewonnener Java-Programmtext ohne Kommentare, überflüssige Leerzeichen usw.

25) Codeerzeuger
Der Codeerzeuger entspricht einem Compiler-Bakkend und generiert Bytecode für die JVM 26 in Abhängigkeit de Sequenz der (Terminal-)Symbole, die der Kellerautomat 22 liefert.

26) JVM
Die virtuelle Maschine für Java-Programme (Java Virtual Machine).

**Literatur**

[1] Huffmann, D. A.: A Method for the Construcition of Minimum-Redndancy Codes. Proc. IRE, 40: 1098-1101, 1952

[2] Ziv, Jacob und Abraham Lempel: A Universal Algorithm for Sequential Data Compression. IEEE Trans. Inform. Theory, IT-23(3):337-343, Mai 1977

[3] Witten, Ian H., Radford M. Neal und John G. Cleary: Arithmetic Coding for Data Compression. Commun. ACM, 30(6):520-540, Juni 1987

[4] Aho, Alfred V., Ravi Sethi und Jeffey D. Ullman: Compilerbau. Addison-Wesley Publishing Company, Bonn, 4. Auflage, 1988


**Bezugszeichenliste**

**Bezugszeichen zur Fig. 4**

$\beta_k$ String von Terminal- und Nonterminalsymbolen
$\sigma$ SoC-Symbol
V Terminal- oder Nonterminalsymbol
S Startsymbol (Nonterminalsymbol)

S1: Die Entwicklung eines gültigen Satzes der Grammatik (eines Programms) beginnt mit dem Startsymbol S. Das Startsymbol S wird auf den Stack gelegt.

S2: Das oberste Symbol V wird vom Stack gelesen.

S3: Prüfen, ob V ein Nonterminalsymbol ist.

S4: Vom linearen Eingangs-SoC-Symbolstrom wird das nächste SoC-Symbol $\sigma$ gelesen.

S5: Falls V ein Nonterminalsymbol ist, wird die Ableitung mit V weiterentwickelt. Durch $\sigma$ wird eine Auswahl $(V, \beta_k) = z^{-1}(\sigma)$ der Menge der Alternativen von V für $V \rightarrow \beta_1|\beta_2| \ldots |\beta_n$ für V bestimmt. Entsprechend der konkreten Auswahl wird V durch den String $\beta_k$ ersetzt.

S6: Der String $\beta_k$ von Symbolen (Terminal- und/oder Nonterminalsymbolen) wird auf den Stack gelegt.

S7: Falls V ein Terminalsymbol ist, wird es ausgegeben.

S8: Prüfen, ob der Stack leer ist.

**Bezugszeichen zu den Fig. 5 und 6**

| | |
|---|---|
| 1 | Java-Quelle |
| 2 | SoC-Encoder |
| 3 | Scanner |
| 4 | Parser |
| 5 | Parse-Baum-Verarbeitung |
| 6 | Symboltabellenspeicher |
| 7 | Zip-Kompressionseinrichtung |
| 8 | Sendeseitige Adaptiervorrichtung |
| 9 | Tabelle der Wahscheinlichkeitsverteilungen der SoC-Symbole |
| 10 | Arithmetischer Coder |
| 11 | Datenverkettung |
| 12 | http-Server |
| 13 | Intranet/Internet |
| 14 | http-Client (Internet-Browser) |
| 15 | SoC-Decoder |
| 16 | Datenextraktion |
| 17 | Arithmetischer Decoder |
| 18 | Zip-Dekompressionseinrichtung |
| 19 | Symboltabellenspeicher des Decoders |
| 20 | Adaptiervorrichtung (empfangsseitig) |
| 21 | Tabelle der Wahrscheinlichkeitsverteilungen der SoC-Symbole |
| 22 | Kellerautomat |
| 23 | Stapelspeicher |
| 24 | Java-Sinke |
| 25 | Codeerzeuger |
| 26 | JVM |

**Patentansprüche**

**1.** Verfahren zur Übertragung einer durch digitale Daten repräsentierten Nachricht, deren Struktur durch eine Grammatik mit grammatikalischen Regeln definiert ist, von einem Sender (1) zu einem Empfänger (15, 24, 26) umfassend die Schritte:

a) Im Sender werden zu einer Codierung (2) die in der Nachricht enthaltenen grammatikalischen Regeln durch Parsen (4) der Nachricht und Erzeugen eines Parse-Baumes in eine SoC-Symbolsequenz überführt, wobei jeder Knoten des Parse-Baumes mit einem SoC-Symbol attributiert wird (5), welches unter allen an dieser Stelle durch die Grammatik erlaubten Regeln die tatsächlich in der Nachricht enthaltene Regel eindeutig identifiziert und wobei die SOC-Symbole gemäß einer festgelegten Reihenfolge der Traversierung aller Knoten des Parse-Baumes zu der SoC-Sequenz verkettet werden;

b) Die SOC-Symbolsequenz wird von dem Sender (1) zu dem Empfänger (15, 24, 26) übertragen (13) und im Empfänger (15, 24, 26) gespeichert;

c) Im Empfänger wird zu einer Dekodierung (15) in einem Keller-Automaten (22) die jedem gespeicherten SoC-Symbol der SoC-Symbolsequenz entsprechende grammatikalische Regel zur Erzeugung von Ausgangsdaten ausgeführt, welche die Nachricht enthalten, wobei ein oberster Eintrag eines Stapelspeichers (23) des Kellerautomaten (22) gemäß einer durch ein eingegebenes SoC-Symbol bestimmten Produktion der Grammatik substituiert wird und noch nicht vollständig bearbeitbare Teile der grammatikalischen Regel in einem Stapelspeicher (23) abgelegt werden und wobei vollständig substituierte Teile der Produktion unmittelbar zu einem Teil eines ausführbaren Programms für einen realen Prozessor oder eine virtuelle Maschine (26) verarbeitet werden (25).

**2.** Verfahren nach Anspruch 1, **gekennzeichnet durch** folgende Schritte:

a) **durch** das Ablegen eines definierten Startsymbols (V) oder Nonterminalsymbols (V) auf einen leeren Stapelspeicher (23) wird der Kellerautomat (22) initialisiert (S1);

b) das oberste Symbol wird vom Stapelspeicher gelesen (S2);

c) es wird geprüft, ob das gelesene Symbol ein Terminalsymbol oder eine Nonterminalsymbol ist (S3);

$d_1$) falls das gelesene Symbol ein Terminalsymbol ist, wird das Symbol ausgegeben (S7) und es wird unabhängig davon, ob weitere Symbole im Stapelspeicher vorhanden sind, mit obigem Schritt (b) fortgefahren und dann terminiert (S8), wenn der Stapelspeicher leer ist (S8), oder

$d_2$) falls das gelesene Symbol ein Nonterminalsymbol ist, wird das nächste SoC-Symbol von einem Eingabestrom gelesen (S4);

e) abhängig vom gelesenen SoC-Symbol wird genau eine Alternative oder Kette von Terminal- und/oder Nonterminalsymbolen aus der für das aktuell bearbeitete Nonterminalsymbol gültigen Menge von alternativ anwendbaren Ersetzungsregeln oder Produktionen ausgewählt (S5);

f) die Kette von Terminal- und/oder Nonterminalsymbolen wird auf den Stapelspeicher gelegt (S6) und zu Schritt (b) zurückgekehrt.

**3.** Verfahren nach Anspruch 1, **dadurch gekennzeichnet, daß**

a) jeder Knoten des Parse-Baumes mit einem SoC-Symbol und der Wahrscheinlichkeitsverteilung aller in diesem Knoten möglichen SoC-Symbole attributiert wird,

b) die Sequenz der SoC-Symbole in Einheit mit den zugeordneten Wahrscheinlichkeitsverteilungen einer Entropie-Codierung unterworfen wird und

c) die Entropie-Decodierung mit denjenigen Wahrscheinlichkeitsverteilungen der SOC-Symbole durchgeführt wird, welche bei der Entropie-Codierung angewendet wurden.

**4.** Verfahren nach Anspruch 3, **dadurch gekennzeichnet, daß**

a) die Wahrscheinlichkeitsverteilung der in einem Knoten anwendbaren Regeln, ausgehend von einer Anfangsverteilung, bei jedem Auftreten eines SoC-Symbols so adaptiert wird, daß die Wahrscheinlichkeit für das aufgetretene SoC-Symbol erhöht und die Wahrscheinlichkeit aller anderen Symbole entsprechend verringert wird,

b) die jeweils aktuelle Verteilung von Auftrittswahrscheinlichkeiten den SoC-Symbolen des entsprechenden Knotentyps zugeordnet wird,

c) die Wahrscheinlichkeitsverteilung aller SoC-Symbole im aktuellen Knoten zusammen mit dem zu kodierenden SoC-Symbol ein Modell für eine arithmetische Codierung bildet,

d) bei der Decodierung ein Ende der Nachricht dadurch erkannt wird, daß der Stapelspeicher leer ist und

e) auf ein bei einer arithmetischen Codierung notwendiges End-Of-Message (EOM) Symbol verzichtet wird.

**5.** Einrichtung zur Übertragung von einer durch digitale Daten repräsentierten Nachricht, deren Struktur durch eine Grammatik mit grammatikalischen Regeln definiert ist, von einem Sender (1) zu einem Empfänger (15, 24, 26), umfassend

a) einen Codierer (2), umfassend

aa) einen Scanner (3) zur Umformung der Nachricht als Sequenz von lesbaren Zeichen in eine Folge von Terminalsymbole,

ab) einen Parser (4) zum Auffinden derjenigen grammatikalischen Regeln, durch deren sukzessive Anwendung die Folge von Terminalsymbolen ursprünglich erzeugt wurde,

ac) einen Mapper (5), der den vom Parser identifizierten Regeln eindeutig SoC-Symbole zuordnet und diese in festgelegter Reihenfolge ausgibt, und

b) einen Decodierer (15), umfassend

ba) einen Kellerautomaten (22), der entsprechend einem obersten Symbol des Stapelspeichers und gegebenenfalls einem anliegenden SoC-Symbol das bereits feststehende Terminalsymbol ausgibt, oder die dem aktuellen Symbol zugeordnete Sequenz von Terminal- und/oder Nonterminalsymbolen auf dem Stapelspeicher ablegt und

bb) ein Lexikon (19), das die Terminalsymbole wieder durch Ketten aus lesbaren Zeichen ersetzt, wobei der Dekodierer vollständig substituierte Teile der Produktion unmittelbar zu einem Teil eines ausführbaren Programmes für einen realen Prozessor oder ein virtuelle Maschine verarbeitet.

**6.** Einrichtung nach Anspruch 5, **dadurch gekennzeichnet, daß** der Scanner (3) als Nachricht ein Programm, das in einem Quelltext oder einer vom Quelltext durch einen Präprozessor abgeleiteten Form vorliegt, in die Folge von Terminalsymbolen umformt und daß ein Codegenerator vorgesehen ist, der aus der Folge von Terminalsymbolen einen ausführbaren Maschinencode oder einen Zwischencode zur Ausführung auf einer virtuellen Maschine erzeugt.

**7.** Einrichtung nach Anspruch 5, umfassend

a) im Sender

aa) eine Tabelle (9), welche Wahrscheinlichkeitsverteilungen von SoC-Symbolen für jeden Knotentyp eines vom Parser erzeugten Parserbaums beinhaltet und deren Inhalt bei einer Initialisierung mit festgelegten Anfangswahrscheinlichkeitsverteilungen für jeden Knotentyp belegt ist,

ab) eine Adaptionsvorrichtung (8), welche die WahrscheinlichkeitsverteilungderSoC-Symbole eines momentan gültigen Knotentyps anhand der bestehenden Wahrscheinlichkeitsverteilung, des zu codierenden SoC-Symbols und des aktuellen Knotentyps aktualisiert und diese neue Wahrscheinlichkeitsverteilung in die Tabelle (9) einträgt, und

ac) eine arithmetische Codiervorrichtung (10), die das jeweils zu codierende SoC-Symbol mit der von der Adaptionsvorrichtung (8) zur Verfügung gestellten aktuell gültigen Wahrscheinlichkeitsverteilung codiert;

b) im Empfänger

ba) eine Tabelle (21), welche die Wahrscheinlichkeitsverteilungen der SoC-Symbole für jeden Knotentyp beinhaltet und deren Inhalt bei der Initialisierung mit festgelegten Anfangswahrscheinlichkeiten für jeden Knotentyp belegt wird,

bb) eine Adaptationsvorrichtung (20), welche die Wahrscheinlichkeitsverteilung der SoC-Symbole des vom Kellerautomaten (22) festgelegten, momentan gültigen Knotentyps anhand der bestehenden Wahrscheinlichkeitsverteilung, des decodierten SoC-Symbols und des aktuellen Knotentyps aktualisiert und diese neue Wahrscheinlichkeitsverteilung in die Tabelle (21) einträgt, und

bc) eine arithmetische Decodiervorrichtung (17), die anhand der von der Adaptationsvorrichtung (20) zur Verfügung gestellten, aktuell gültigen Wahrscheinlichkeitsverteilung des aktuellen Knotentyps das nächste SoC-Symbol decodiert und zu einer weiteren Verarbeitung dem Kellerautomaten (22) übergibt.

## Claims

**1.** Method for the transmission of a message, represented by digital data, whose structure is defined by a grammar with grammatical rules, from a transmitter (1) to a receiver (15, 24, 26), comprising the steps:

a) In the transmitter, for the purpose of a coding (2), the grammatical rules contained in the message are converted into an SoC symbol sequence by parsing (4) of the message and generation of a parsing tree, each node of the parsing tree being attributed (5) with an SoC symbol which, amongst all rules permitted by the grammar at this point, unequivocally identifies the rule actually contained in the message, and the SoC symbols being linked, according to a determined sequence of traversing of all nodes of the parsing tree, to form the SoC sequence;

b) The SoC symbol sequence is transmitted (13) from the transmitter (1) to the receiver (15, 24, 26) and stored in the receiver (15, 24, 26);

c) In the receiver, for the purpose of a decoding (15), the grammatical rule corresponding to each stored SoC symbol of the SoC symbol sequence is executed in a push-down automaton (22) for the purpose of generating output data which contains the message, a topmost input of a stack storage (23) of the push-down automaton (22) being substituted according to a production of the grammar determined by an input SoC symbol and parts of the grammatical rule which have not yet been fully processed being stored in a stack storage (23) and fully substituted parts of the production being directly processed (25) to form a part of an executable program for a real processor or a virtual machine (26).

**2.** Method according to Claim 1, **characterized by** the following steps:

a) the push-down automaton (22) is initialised (S1) by the storage of a defined start symbol (V) or non-terminal symbol (V) on an empty stack storage (23);

b) the topmost symbol is read (S2) from the stack storage;

c) it is determined (S3) whether the read symbol is a terminal symbol or a non-terminal symbol;

d1) if the read symbol is a terminal symbol, the symbol is output (57) and, irrespective of whether there are further symbols present in the stack storage, the above step (b) is continued and then terminated (S8) when the stack storage is empty (S8), or

d2) if the read symbol is a non-terminal symbol, the next SoC symbol is read (S4) from an input stream;

e) depending on the read SoC symbol, precisely one alternative or string of terminal and/or non-terminal symbols is selected (S5) from the quantity of alternatively applicable replacement

rules or productions that is valid for the currently processed non-terminal symbol;

f) the string of terminal and/or non-terminal symbols is placed on the stack storage (S6) and the procedure returns to step (b).

**3.** Method according to Claim 1,
**characterized in that**

a) each node of the parsing tree is attributed with an SoC symbol and with the probability distribution of all possible SoC symbols in this node,

b) the sequence of the SoC symbols are subjected, in unity with the assigned probability distributions, to an entropy coding, and

c) the entropy decoding is performed with those probability distributions of the SoC symbols which were used in the entropy coding.

**4.** Method according to Claim 3,
**characterized in that**

a) starting from an initial distribution, the probability distribution of the rules which are applicable in a node are adapted upon each occurrence of an SoC symbol such that the probability is increased for the SoC symbol which has occurred and the probability of all other symbols is correspondingly reduced,

b) the respectively current distribution of occurrence probabilities is assigned to the SoC symbols of the corresponding node type,

c) the probability distribution of all SoC symbols in the current node, together with the SoC symbol to be coded, forms a model for an arithmetic coding,

d) in decoding, an end of the message is recognized **in that** the stack storage is empty, and

e) an end-of-message (EOM) symbol, necessary in an arithmetic coding, is dispensed with.

**5.** Facility for the transmission of a message, represented by digital data, whose structure is defined by a grammar with grammatical rules, from a transmitter (1) to a receiver (15, 24, 26), comprising

a) a coder (2), comprising

aa) a scanner (3) for converting the message, as a sequence of readable characters, into a sequence of terminal symbols,

ab) a parser (4) for locating those grammatical rules through whose successive application the sequence of terminal symbols was originally generated,

ac) a mapper (5) which unequivocally assigns SoC symbols to the rules identified by the parser and outputs these SoC symbols in a determined sequence, and

b) a decoder (15), comprising

ba) a push-down automaton (22) which outputs the already established terminal symbol according to a topmost symbol of the stack storage and, if applicable, an adjacent SoC symbol, or stores on the stack storage the sequence of terminal and/or non-terminal symbols assigned to the current symbol, and

bb) a lexicon (19) which re-replaces the terminal symbols by strings of readable characters, the decoder directly processing fully substituted parts of the production to form a part of an executable program for a real processor or a virtual machine.

**6.** Facility according to Claim 5,
**characterized in that**
as a message, the scanner (3) converts into the sequence of terminal symbols a program which is present in a source text or in a form derived from the source text by a pre-processor, and a code generator is provided which generates, from the sequence of terminal symbols, an executable machine code or an intermediate code for execution on a virtual machine.

**7.** Facility according to Claim 5, comprising

a) in the transmitter

aa) a table (9) which contains probability distributions of SoC symbols for each node type of a parsing tree generated by the parser, and whose content is occupied, upon an initialization, by determined initial probability distributions for each node type,

ab) an adaptation device (8)which updates the probability distribution of the SoC symbols of an instantaneously valid node type on the basis of the existing probability distribution, the SoC symbol to be coded and the current node type, and enters this new probability distribution in the table (9), and

ac) an arithmetic coding device (10) which codes the respective SoC symbol to be coded with the currently valid probability distribution provided by the adaptation device (8);

b) in the receiver

ba) a table (21) which contains the probability distributions of the SoC symbols for each node type and whose content is occupied, upon an initialization, by determined initial probabilities for each node type,

bb) an adaptation device (20) which updates the probability distribution of the SoC symbols of the instantaneously valid node type, determined by the push-down automaton (22), on the basis of the existing probability distribution, the decoded SoC symbol and the current node type, and enters this new probability distribution in the table (21), and

bc) an arithmetic decoding device (17) which decodes the next SoC symbol on the basis of the currently valid probability distribution of the current node type provided by the adaptation device (20), and transfers it to the push-down automaton (22) for the purpose of a further processing.

**Revendications**

1. Procédé pour la transmission d'un message représenté par des données numériques, dont la structure est définie par une grammaire avec des règles grammaticale, d'un émetteur (1) à un récepteur (15, 24, 26), comprenant les étapes suivantes :

   a) Dans l'émetteur, les règles grammaticales contenues dans le message sont converties pour un codage (2) par analyse syntaxique (4) du message et génération d'un arbre d'analyse syntaxique en une séquence de symboles SoC, chaque noeud de l'arbre d'analyse syntaxique étant attribué avec un symbole SoC (5), lequel identifie clairement la règle effectivement contenue dans le message avec toutes les règles autorisées ici par la grammaire, et les symboles SoC étant enchaînés pour former la séquence SoC selon un ordre de succession défini de traversée de tous les noeuds de l'arbre d'analyse syntaxique ;
   b) la séquence de symboles SoC est transmise (13) par l'émetteur (1) au récepteur (15, 24, 26) et mémorisée dans le récepteur (15, 24, 26) ;
   c) dans le récepteur, la règle grammaticale, appropriée à chaque symbole SoC mémorisé, de la séquence de symboles SoC est exécutée pour un décodage (15) dans un automate de pile (22) pour la génération de données de sortie qui contiennent le message, moyennant quoi un enregistrement supérieur dune pile (23) de l'automate de pile (22) est substitué selon une production de la grammaire déterminée par un symbole SoC entré, des parties de la règle grammaticale, qui ne peuvent pas encore être traitées complètement, sont stockées dans une pile (23) et des parties de la production, qui sont complètement substituées, sont traitées (25) directement en une partie d'un programme exécutable pour un processeur réel ou une machine virtuelle (26).

2. Procédé selon la revendication 1, **caractérisé par** les étapes suivantes :

   a) par l'enregistrement d'un symbole de démarrage (V) défini ou un symbole non-terminal (V) sur une pile (23) vide, l'automate à pile (22) est initialisé (S1);
   b) le symbole supérieur est lu par la pile (S2);
   c) on vérifie si le symbole lu est un symbole terminal ou un symbole non-terminal (S3);
   $d_1$) si le symbole lu est un symbole terminal, le symbole est délivré (S7) et il est poursuivi avec l'étape suivante (b) Indépendamment du fait que d'autres symboles sont présents dans la pile et est terminé (S8) dans les cas où la pile est vide (S8), ou bien
   $d_2$) si le symbole lu est un symbole non-terminal, le symbole SoC suivant est lu par un flux d'entrée (S4);
   e) selon le symbole SoC lu, on sélectionne de façon précise une alternative ou une chaîne de symboles terminaux et/ou de symboles non-terminaux à partir de la quantité, valable pour le symbole non-terminal actuellement traité, de règles de substitution ou de productions applicables au choix (S5) ;
   f) la chaîne de symboles terminaux et/ou de symboles non-terminaux est placée sur la pile (S6) et est retournée à l'étape (b)

3. Procédé selon la revendication 1, **caractérisé en ce que**

   a) chaque noeud de l'arbre d'analyse syntaxique est attribué avec un symbole SoC et la distribution de probabilité de tous les symboles SoC possibles dans ce noeud,
   b) la séquence des symboles SoC est soumise, conjointement avec les distributions de probabilité attribuées, à un codage d'entropie et
   c) le décodage d'entropie est effectué avec les distributions de probabilité des symboles SoC

qui sont utilisées lors du codage d'entropie.

**4.** Procédé selon la revendication 3, **caractérisé en ce que**

a) la distribution de probabilité des règles appilcables dans un noeud est adaptée, à partir dune distribution initiale, lors de chaque apparition d'un symbole SoC de telle façon que la probabilité augmente pour le symbole SoC apparu et que la probabilité de tous les autres symboles est réduite en conséquence.
b) la distribution respectivement actuelle des probabilités d'occurrence est attribuée aux symboles SoC du type de noeud approprié,
c) la distribution de probabilité de tous les symboles SoC dans le noeud actuel forme, conjointement avec le symbole SoC à coder, un modèle pour un codage arithmétique,
d) lors du décodage, une fin de message est identifiée par le fait que la pile est vide, et
e) on renonce à un symbole de fin de message (EOM) nécessalre lors d'un codage arithmétique.

**5.** Dispositif pour la transmisslon d'un message représenté par des données numériques, dont la structure est définie par une grammaire avec des règles grammaticales, d'un émetteur (1) à un récepteur (15, 24, 26), comprenant :

a) un codeur (2) comprenant
aa) un scanner (3) pour la transformation du message sous la forme dune séquence de caractères lisibles en une séquence de symboles terminaux,
ab) un programme d'analyse syntaxique (4) pour la détection des règles grammaticales, par l'application successive desquelles la séquence de symboles terminaux a été générée au départ,
ac) un mappeur (5), qui attribue distinctement des symboles SoC aux règles identifiées par le programme d'analyse syntaxique et les émet dans l'ordre de succession défini, et
b) un décodeur (15) comprenant
ba) un automate de pile (22), qui délivre le symbole terminal déjà fixé selon un symbole supérieur de la pile et éventuellement un symbole SoC en attente, ou qui stocke la séquence attribuée au symbole actuel de symboles terminaux et/ou non terminaux sur la pile et
bb) un lexique (19), qui remplace les symboles terminaux à nouveau par des chaînes constituées de caractères lisibles, moyennant quol le décodeur traite des parties complètement substituées de la production directement en une partle d'un programme exécutable pour un processeur réel au une machine virtuelle.

**6.** Dispositif selon la revendication 5, **caractérisé en ce que**
le scanner (3) transforme sous la forme de message un programme, qui est présent dans un texte source ou une forme déduite du texte source par un préprocesseur, en la séquence de symboles terminaux et **en ce qu'**il est prévu un générateur de code, qui génère à partir de la succession de symboles terminaux un code machine réalisable ou un code intermédiaire pour l'exécution sur une machine virtuelle.

**7.** Dispositif selon la revendication 5, comprenant

a) dans l'émetteur
aa) un tableau (9), qui contient des distributions de probabilité de symboles SoC pour chaque type de noeud d'un arbre d'analyse syntaxique généré par le programme d'analyse syntaxique et dont le contenu est affecté lors d'une initialisation avec des distributions définies de probabilité initiale pour chaque type de noeud,
ab) un dispositif d'adaptation (8), qui actualise la distribution de probabilité des symboles SoC d'un type de noeud momentanément valable à l'aide de la distribution de probabilité existante, du symbole SoC à coder et du type de code actuel et enregistre cette nouvelle distribution de probabilité dans le tableau (9) et
ac) un dispositif de codage (10) arithmétique, qui code le symbole SoC à coder respectivement avec la distribution de probabilité actuellement valable et mise à disposition par le dispositif d'adaptation (8);
b) dans le récepteur
ba) un tableau (21), qui contient les distributions de probabilité des symboles SoC pour chaque type de noeud et dont le contenu est affecté lors de l'initialisation avec des probabilités initiales définies pour chaque type de noeud,
bb) un dispositif d'adaptation (20), qui actualise la distribution de probabilité des symboles SoC du type de noeud actuellement valable et défini par l'automate de pile (22) à l'aide de la distribution de probabilité existante, du symbole SoC décodé et du type de noeud actuel et enregistre cette nouvelle distribution de probabilité dans le tableau (21), et
bc) un dispositif de décodage (17) arithmétique, qui décode le symbole SoC suivant à l'alde de la distribution de probabilité actuellement valable et mise à disposition par le dispositif d'adaptation (20) et la transmet à l'automate de pile (22) pour un traitement ultérieur.

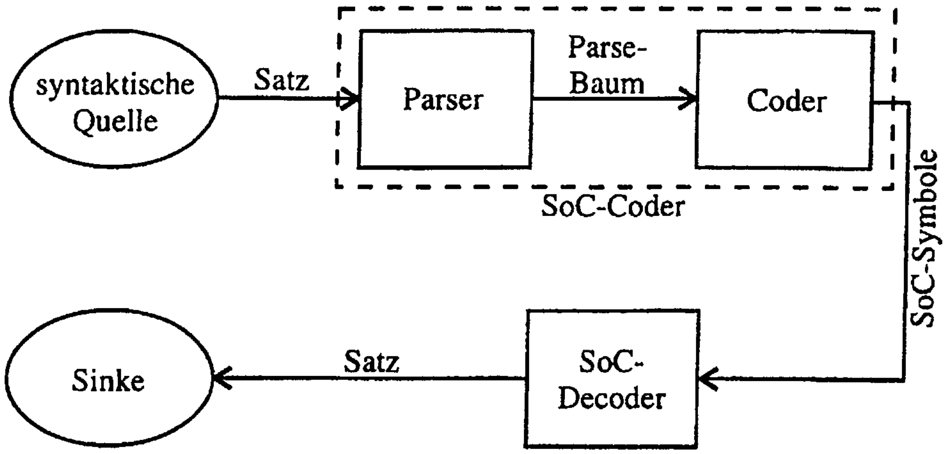


Figur 1

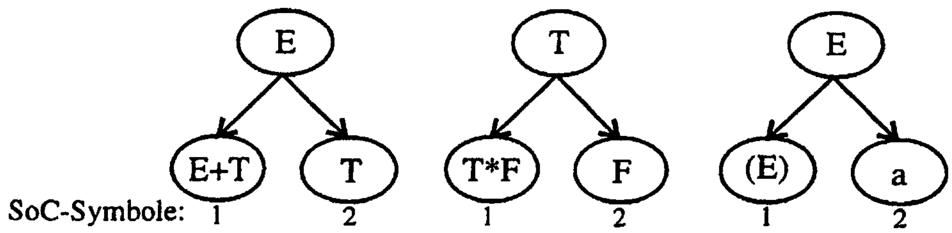


Figur 2

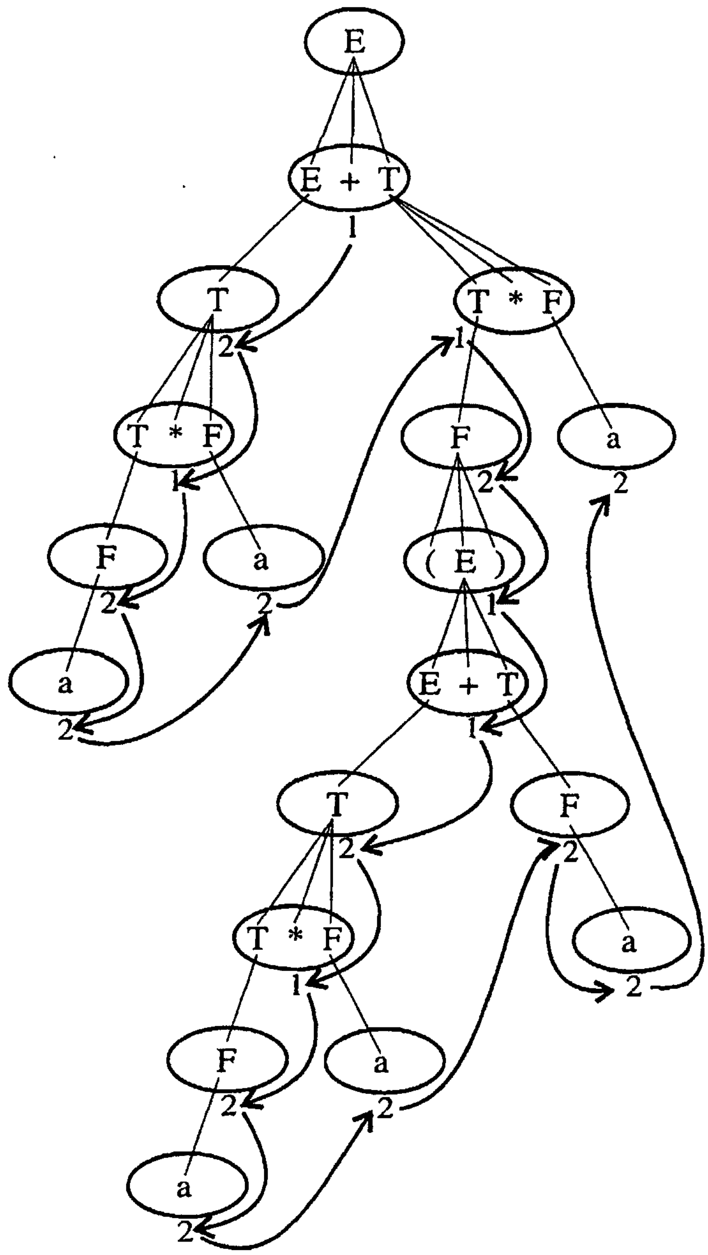


Figur 3

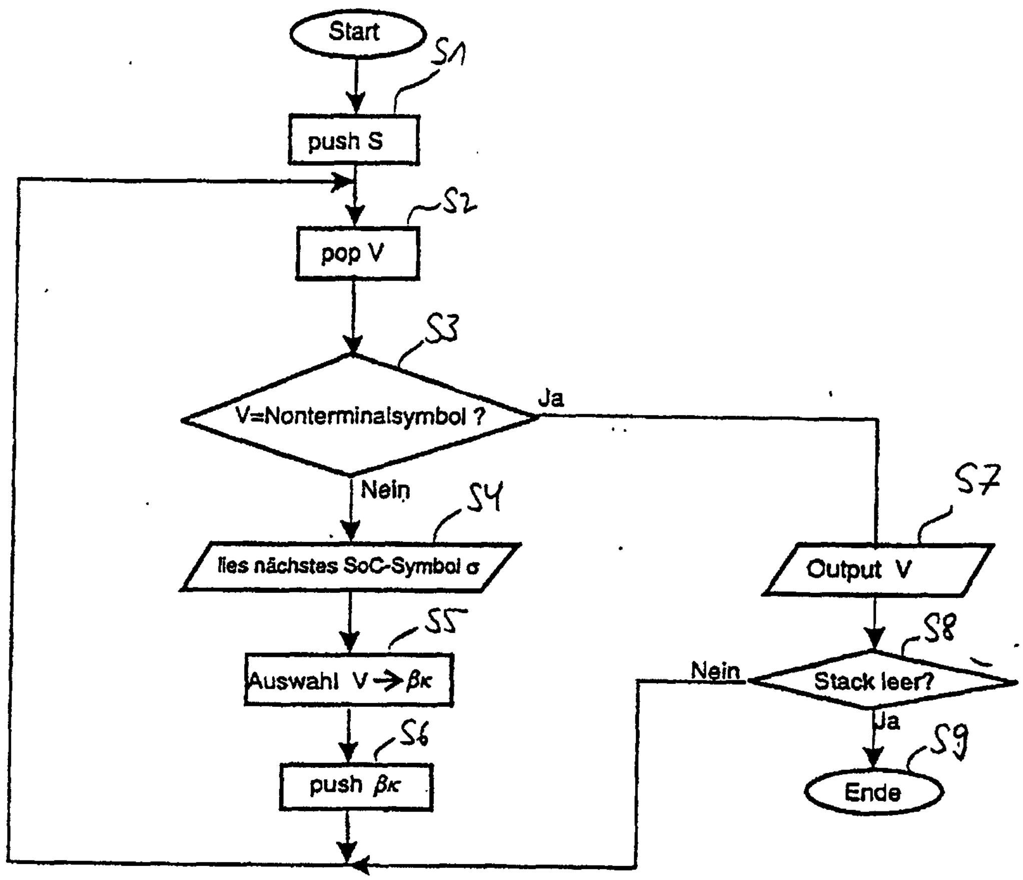
Start
S1
push S
S2
pop V
S3
V=Nonterminalsymbol ?
Ja
Nein
S4
lies nächstes SoC-Symbol σ
S5
Auswahl V→βκ
S6
push βκ
S7
Output V
S8
Stack leer?
Nein
Ja
S9
Ende

Figur 4

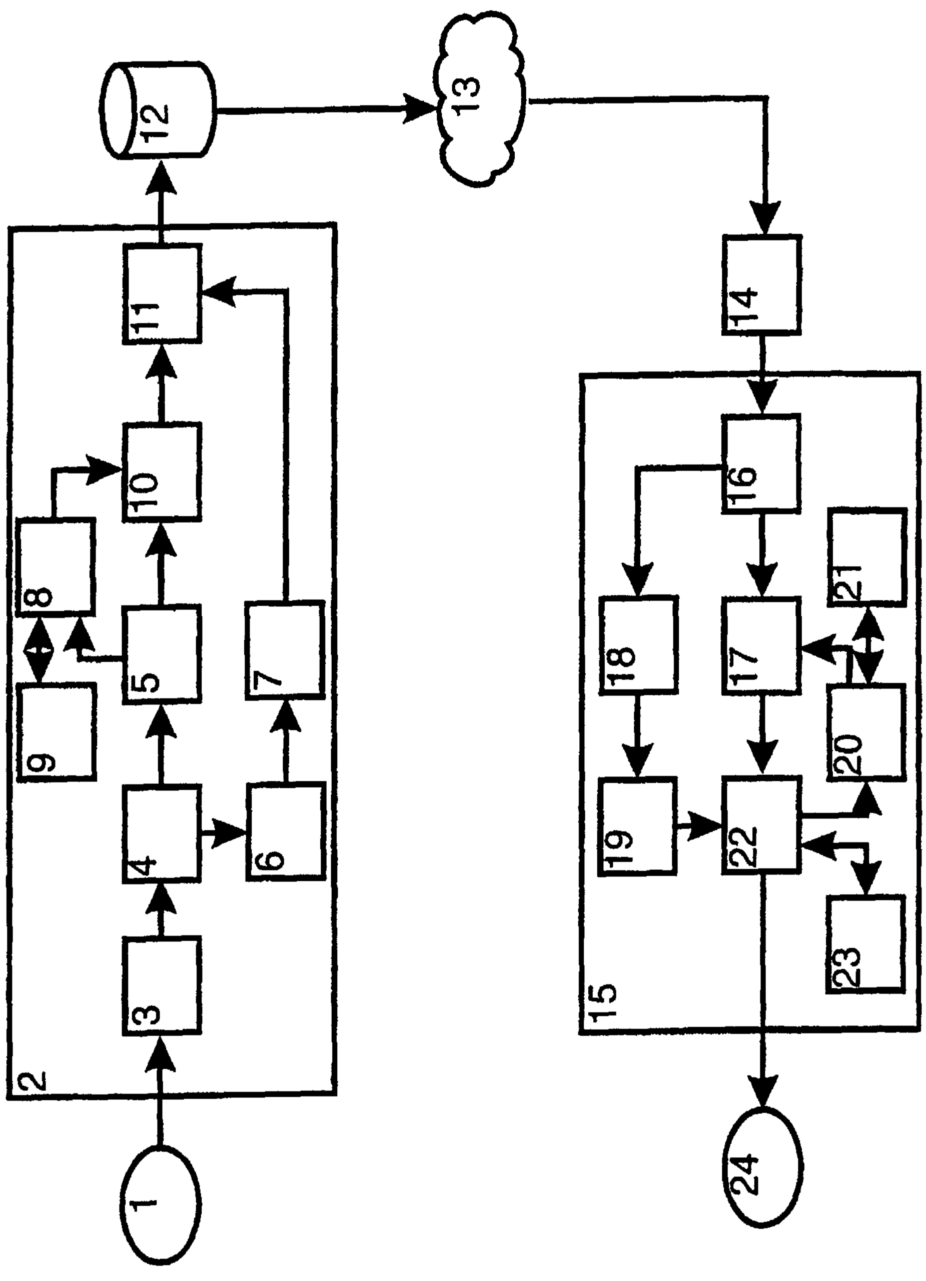


Figur 5

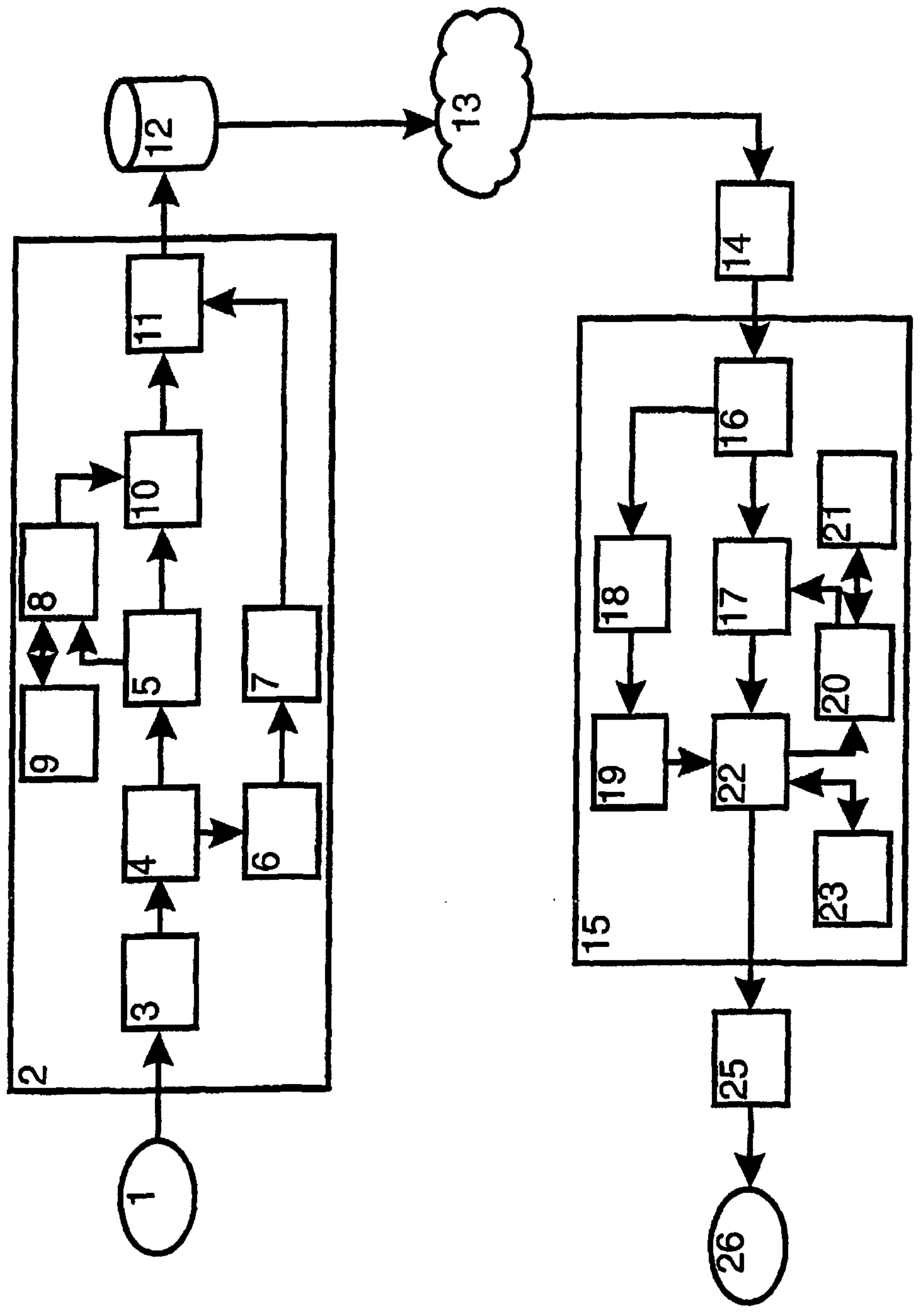


Figur 6